## Europäisches Patentamt

## European Patent Office

## Office européen des brevets

(1) Publication number: **0 046 355**
**B1**

(12) **EUROPEAN PATENT SPECIFICATION**

(45) Date of publication of patent specification: **05.11.86**

(21) Application number: **81303610.0**

(22) Date of filing: **06.08.81**

(51) Int. Cl.⁴: **C 30 B 31/10,** C 30 B 25/08,
C 03 B 19/06

(54) Quartz tube for thermal processing of semiconductor substrates.

(30) Priority: **18.08.80 JP 113149/80**

(43) Date of publication of application:
**24.02.82 Bulletin 82/08**

(45) Publication of the grant of the patent:
**05.11.86 Bulletin 86/45**

(84) Designated Contracting States:
**DE FR GB NL**

(56) References cited:
**FR-A-2 126 098**
**FR-A-2 194 663**
**US-A-2 125 912**
**US-A-4 102 666**

(73) Proprietor: **FUJITSU LIMITED**
**1015, Kamikodanaka Nakahara-ku**
**Kawasaki-shi Kanagawa 211 (JP)**

(72) Inventor: **Kawase, Nobuo**
**3416-7 Onuma Sagamihara-shi**
**Kanagawa 229 (JP)**
Inventor: **Aigo, Masayoshi**
**2989 Sugao Takatsu-ku**
**Kawasaki-shi Kanagawa 213 (JP)**

(74) Representative: **Lawrence, Peter Robin**
**Broughton et al**
**GILL JENNINGS & EVERY 53-64 Chancery Lane**
**London WC2A 1HN (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

It is common to have to subject semiconductor substrates to thermal processing, such as oxidation, evaporation, chemical vapour deposition or diffusion of impurities. The substrates have to be held within a holder during such processing. Conventionally the holder comprises a transparent fused quartz tube. Such holders are advantageous because they are non-porous, they can be produced from very pure silica, and they are not easily contaminated with unwanted impurities. In use the substrates to be processed are generally mounted on susceptors or other carriers within the holder during thermal processing.

A disadvantage of the use of fused quartz tubes is that it can be difficult to make them fully symmetrical with a uniform outer diameter. Thermal processing is often conducted by inserting the tube within a cylindrical chamber in a furnace but because of the variations in the outer diameter it is necessary to make a rather large allowance for the gap between the outer surface of the tube and the inner surface of the furnace chamber, and this results in reduced thermal efficiency.

Another disadvantage is that non-uniformity of the surface of the tube can result in variations in temperature within the tube, and in particular high temperature spots within the tube. This in turn can result in unwanted reactions occurring in or on the semiconductor substrates. These variations arise from the so-called lens effect which can be caused by variations in the surface of the tube during irradiation of the tube by infrared rays.

Another disadvantage is that the thickness of the wall of a fused quartz tube is generally limited to from 3 or 4 mm and this results in rather low thermal capacitance.

A liner tube may be provided in the gap between the processing tube and a cylindrical heating chamber in which it is positioned, so as to promote uniformity of heating within the tube. However this liner tube increases the bulk of the processing apparatus as a whole, and consequently increases the consumption of power necessary for heating the substrates within the tube. Thermal processing of semiconductor substrates is generally carried out at temperatures of from 1150 to 1300°C. Another disadvantage of conventional fused quartz tubes is that they tend to deform at temperatures above 1200°C and so many thermal processing operations result in deformation in the tube. This deformation can be sufficiently serious that quartz susceptors or other carriers in the tube, and also sometimes semiconductor substrates loaded on them, may deform or even crack. Also friction between the deformed tube and the susceptors results in wear and the friction produced during the insertion and removal of them from the tube may liberate fine powdered quartz that may contaminate the surface of the substrates. Accordingly usage of the tube must terminate before unacceptable deformation occurs, and so conventional tubes have only a short service life.

Japanese patent Application 51-79581 discloses a fused quartz tube in which the walls of the central portion are thicker than the walls of the end portions. However, this tube still has a tendency to deform too easily.

In U.S. 4,102,666 the wall of a quartz glass tube has an outer layer of uniformly fine crystalline silica that is preferably cristobalite. The wall contains crystallisation promoting nuclei. It is mentioned that ground or unground quartz glass elements may be connected to the ends of the tube.

In FR—A—2194663 a quartz tube is provided with an outer layer of sintered rock crystal, again including crystallisation nuclei. The ends of the tube are closed by end pieces which are discs that are connected to outwardly extending flanges at the ends of the tube.

In the invention a quartz tube that may be used for thermal processing of semi-conductor substrates comprises a double layered central tube having an external sintered crystalline quartz layer fused with an internal transparent fused quartz layer and is characterised in that the external sintered crystalline quartz layer and the internal transparent fused quartz layer are formed of pure quartz, both ends of the sintered crystalline quartz layer are tapered and each end of the central tube is fused with the end of a transparent fused quartz end tube having substantially the same inner diameter.

Thus the quartz tube comprises an inlet end tube fused to one end of the double layer tube and a tail end tube fused to the other end of the double layer tube, each of the end tubes being of transparent fused quartz and having, at least in the region adjacent to where they are fused to the double layer tube, an internal diameter substantially the same as the internal diameter of the inner tube of the double layer tube.

Both layers are free of crystallisation nuclei and so are formed of pure quartz. Whereas in, for instance, U.S. 4,102,666 the formation of the outer layer involves the use of crystallisation nuclei in the present invention the outer, sintered, crystalline quartz layer is best formed by sintering a composition consisting of finely divided crystalline quartz particles.

One method according to the invention for making the defined quartz tube comprises depositing a composition consisting of finely divided crystalline quartz particles on the inner surface of a cylindrical mould while rotating the mould around its longitudinal axis, and heating the quartz by a heater located on the longitudinal axis of the mould so as to sinter the crystalline quartz particles as a whole and to fuse with each other the particles on and near the inner surface of the deposited particulate layer, thus forming a double layer tube having an internal transparent fused quartz layer fused with an external sintered crystalline quartz layer, tapering the ends of the external layer of the tube and then fusing the open ends of the tube to transparent fused quartz end tubes having substantially the same internal diameter.

Another method according to the invention for producing the quartz tube comprises locating a transparent fused quartz tube coaxially within a cylindrical mould with a thin annular gap between the tube and the mould, filling this gap with a quartz composition consisting of finely divided crystalline quartz particles, compacting the composition centrifugally by rotating the mould, and heating the composition with a heater located coaxially with the tube so as to cause sintering of the particles as a whole and fusing of the particles with the internal transparent fused quartz tube, thus forming a double layered tube having an internal transparent fused quartz layer fused with an external crystalline quartz layer, tapering the ends of the external layer of the tube and then fusing the open ends of the tube to transparent fused quartz end tubes having substantially the same internal diameter.

The invention also includes methods for the thermal processing of semiconductor substrates characterised in that the substrates are held during the processing in a tube as defined above.

The inner layer of the double layer tube may have a wall thickness of, for instance, 2 to 5 mm. The thickness of the outer layer is generally greater than the thickness of the inner layer.

The invention is now described with reference to the accompanying drawings in which:

Figure 1 is a sectional side view of one form of a quartz tube embodying this invention.

Figure 2 is a cross view taken along the lines II—II of Figure 1.

Figure 3 is a diagram showing the relation between heating time and inner diameter of quartz tubes.

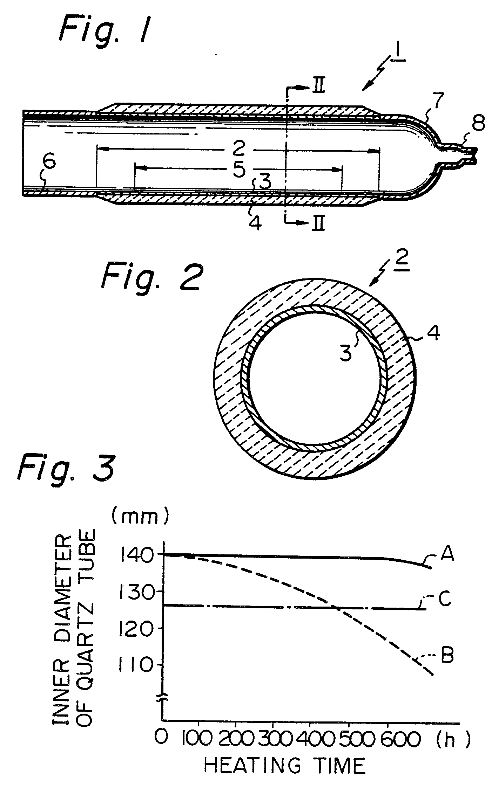

As shown in Figures 1 and 2, the quartz tube 1 has a double-layered central tube portion 2. This central tube 2 consists of an external sintered crystalline quartz layer 4 fused with an internal transparent fused quartz layer 3. The quartz tube 1 is inserted through a furnace, the length of the inserted region 5 is shorter than the length of the double-layered tube portion 2, so as to heat uniformly the reaction zone within the tube 1. Both ends of the double-layered tube 2 are fused with the ends of two end tubes 6, 7, respectively. The end tube 7 has a tail tube 8. The fused ends of these ends tube 6, 7 have substantially the same inner diameter as that of the central tube 2, and they are made from transparent fused quartz.

In one method of forming the tube, finely divided crystalline quartz particles from about 105 µm to about 62 µm (150 mesh to about 250 mesh) are charged on the inner surface of a cylindrical mould, which is rotated at a high speed so as to press them centrifugally onto its surface. They are heated from the centre of the cylindrical mould. The quartz particles are fused on and near the inner surface of its deposited layer and forms a fused quartz layer 3. The rest of the quartz particles are sintered and form a crystalline quartz layer 4, the density of which increases transiently from the fused layer 3. The outer surface of the sintered layer 4 is defined by the inner surface of the mould, therefore its outer surface is formed with accuracy in size, shape and evenness. The fused quartz layer 3 may be at least 2 mm thick. If the layer is too thin, pin holes or pits appear and the surface wears off easily due to friction with the susceptors and a cleaning chemical solution etches the layer 3 and penetrates up to the porous sintered crystalline quartz layer 4.

In another method a fused quartz tube is inserted within a cylindrical mould. Finely divided crystalline quartz particles are filled in the gap between the tube and the mould. Then, the particles are compacted, centrifugally by rotating said mould at a high speed, and heated from the centre of the cylindrical mould through the fused quartz tube and sintered to each other and to the inserted tube. This double-layered tube can be formed with a fuzed quartz layer 3 of any desired thickness, e.g. from 3 to 5 mm. Therefore, the above-mentioned defects of the internal fused quartz layer 3 due to its thinness are avoided.

Both ends of the outer surfaces of the double layer tube are then tapered, so as to promote contact with the flame of the burner, and fused with end tubes 6 and 7 respectively. The end tube 6 serves as an inlet tube for susceptors loaded with substrates and the end tube 7 comprises a tail tube 8 and serves as an inlet for reactive gas.

The resultant quartz tube 1 may be inserted in an appropriate furnace. Susceptors of very pure quartz loaded with a plurality of semiconductor substrates may be introduced through the end tube 6 into the region 5. Heaters (not shown) of the furnace positioned to face the outer layer 4 heat the region 5 up to the desired temperature. For instance substrates located in the region 5 may be heated to from 900 to 1200°C for the oxidation of silicon wafers of 1100 to 1250°C for the diffusion of impurities such as phosphorus, boron or antimony.

The quartz tube according to the invention has a double layered central tube portion the size and shape of which can be made with relative accuracy and generally the major thickness of the wall is occupied by an opaque sintered crystalline quartz layer. This has a high deformation temperatures since whereas fused quartz deforms at about 1200°C sintered crystalline quartz only deforms at temperature of above 1700°C. Some flattening of a quartz tube during heating is acceptable provided it is not too great. As a result of the invention it is possible to heat the tubes for longer or to higher temperatures while avoiding undesirable flattening or at least for longer periods before undesirable flattening occurs.

For instance if a quartz tube has an original inner diameter of 140 mm the minimum acceptable inner diameter for use might be 127 mm. In Figure 3 we show the variation in inner diameter of two tubes A and B having an initial inner diameter of 140 mm and compared to the minimum acceptable inner diameter C of 127 mm. Tube A is a tube according to the invention having a double layered central tube 2 consisting of an external sintered crystalline quartz layer 6 mm in thickness and an internal transparent fused quartz layer 2 mm in thickness. This tube begins to deform only after about 600 hours thermal processing and even then its internal diameter is still well above the critical value C.

Tube B however is a prior art tube formed of a single layer of transparent fused quartz 3 or 4 mm in thickness. This tube begins to distort after only short service and its internal diameter decreases below the critical value C within about 450 hours.

This demonstrates the increased service life of the tube of the invention.

The new tubes are also advantageous since the inner layer has a non-porous and even surface and quartz powder is not produced by friction while introducing or removing the substrate susceptors, thus avoiding contamination of the substrates by quartz powder.

The tubes are also advantageous in that the greater uniformity and stability that they permit prevents abnormally high temperature hot spots being formed in the reaction zone within the tube, with consequential formation of abnormal functional layers on the substrates. The invention thus permits the production of substrates that are not contaminated by quartz powder and that have a consistent high quality.

The tube of the invention has a larger thermal capacity than conventional tubes and this also promotes uniform heating in the processing zone without the necessity for providing a linear tube outside the processing tube. The tubes of the invention contribute to the automatic processing of substrates and to increasing their production yield and quality as well as to lowering their production cost.

**Claims**

1. A quartz tube suitable for thermal processing of semiconductor substrates and comprising a double-layered central tube having an external sintered crystalline quartz layer fused with an internal transparent fused quartz layer, characterised in that the external sintered crystalline quartz layer and the internal transparent fused quartz layer are formed of pure quartz, both ends of the sintered crystalline quartz layer are tapered and each end of the central tube is fused with the end of a transparent fused quartz end tube having substantially the same inner diameter.

2. A tube according to claim 1 characterised in that the wall thickness of the outer layer is greater than the wall thickness of the inner layer.

3. A method of forming a tube according to claim 1 or 2 by depositing a composition consisting of finely divided crystalline quartz particles on the inner surface of a cylindrical mould while rotating the mould around its longitudinal axis and heating the quartz by a heater located on the longitudinal axis of the mould so as to sinter the crystalline quartz particles as a whole and to fuse with each other the particles on and near the inner surface of the deposited particulate layer, thus forming a double layer tube having an internal transparent fused quartz layer fused to an external sintered crystalline quartz layer, tapering the ends of said external layer of said tube, and then fusing the open ends of the tube to transparent fused quartz end tubes having substantially the same internal diameter.

4. A method of forming a tube according to claim 1 or 2 comprising locating a transparent fused quartz tube coaxially within a cylindrical mould with a thin annular gap between the tube and the mould, filling this gap with a quartz composition consisting of finely divided crystalline quartz particles compacting the composition centrifugally by rotating said mould and heating this composition with a heater located coaxially with the tube, so as to cause sintering of the particles as a whole and fusing of the particles with the internal transparent fused quartz tube, thus forming a double-layered tube having an internal transparent fused quartz layer fused with an external sintered crystalline quartz layer, tapering the ends of said external layer of said tube and then fusing the open ends of the tube to transparent fused quartz end tubes having substantially the same internal diameter.

5. A method for the thermal processing of semiconductor substrates characterised in that the substrates are heated while held within a tube according to claims 1 or 2.

**Patentansprüche**

1. Quarzrohr, welches zur thermischen Behandlung von Halbleitersubstraten geeignet ist und ein doppelschichtiges zentrales Rohr umfaßt, das eine äußere, gesinterte kristalline Quarzschicht umfaßt, die mit einer inneren, transparenten, geschmolzenen Quarzschicht verschmolzen ist, dadurch gekennzeichnet, daß die externe, gesinterte, kristalline Quarzschicht und die interne, transparente, geschmolzene Quarzschicht aus reinem Quarz gebildet sind, beide Enden der gesinterten, kristallinen Quarzschicht abgeschrägt sind und jedes Ende des zentralen Rohrs mit dem Ende eines transparenten, geschmolzenen, Quarzendrohres verbunden ist, welches im wesentlichen denselben inneren Durchmesser hat.

2. Rohr nach Anspruch 1, dadurch gekennzeichnet, daß die Wanddicke der äußeren Schicht größer als die Wanddicke der inneren Schicht ist.

3. Verfahren zur Herstellung eines Rohrs nach Anspruch 1 oder 2, durch Niederschlagen einer Zusammensetzung, die aus fein verteilten kristallinen Quarzteilchen besteht, auf der inneren Oberfläche einer zylindrischen Form, während die Form um ihre Längsachse gedreht wird, und Erhitzen des Quarzes durch einen Heizer, der auf der Längsachse der Form angeordnet ist, um so die kristallinen Quarzteilchen als ein Ganzes zu sintern und um die Teilchen auf und nahe der inneren Oberfläche der niedergeschlagenen teilchenförmigen Schicht miteinander zu verschmelzen, um so ein doppelschichtiges Rohr zu bilden, das eine interne, transparente, geschmolzene Quarzschicht aufweist, die an eine externe, gesinterte, kristalline Quarzschicht angeschmolzen ist, Abschrägen der Enden der externen Schicht des genannten Rohrs und dann Schmelzen der oberen Enden des Rohrs an die transparenten, geschmolzenen Quarzendrohre, welche im wesentlichen denselben inneren Durchmesser haben.

4. Verfahren zur Bildung eines Rohrs nach Anspruch 1 oder 2, gekennzeichnet durch Anordnen eines transparenten, geschmolzenen Quarzrohres koaxial innerhalb einer zylindrischen Form mit einem dünnen Ringspalt zwischen dem Rohr und der Form, Füllen dieses Spaltes mit einer Quarzzusammensetzung, die aus fein verteilten kristallinen Quarzteilchen besteht, zentrifugales Verdichten der Zusammensetzung durch die Rotation der genannten Form und Erhitzen dieser Zusammensetzung mit einem Heizer, der koaxial innerhalb des Rohrs angeordnet ist, um so eine Sinterung der Teilchen als Ganzes und ein Verschmelzen der Partikel mit dem inneren, transparenten, geschmolzenen Quarzrohr zu verursachen, um so ein droppelschichtiges Rohr zu bilden, welches eine interne, transparente, geschmolzene Quarzschicht hat, die mit einer externen, gesinterten, kristallinen Quarzschicht verschmelzen ist, Abschrägen der Enden der genannten externen Schicht des genannten Rohres und dann Anschmelzen der oberen Enden des Rohres an transparente, geschmolzene Quarzendrohre, welche im wesentlichen denselben inneren Durchmesser haben.

5. Verfahren zur thermischen Behandlung von Halbleitersubstraten, dadurch gekennzeichnet, daß die Substrate erhitzt werden, während sie innerhalb eines Rohres nach Anspruch 1 oder 2 gehalten werden.

**Revendications**

1. Tube de quartz convenant pour le traitement thermique de substrats semiconducteurs et comprenant un tube central à double couche qui possède une couche de quartz cristallin fritté externe fusionnée avec une couche de quartz fondu transparent interne, caractérisé en ce que la couche de quartz cristallin fritté externe et la couche de quartz fondu transparent interne sont formées en quartz pur, les deux extrémités de la couche de quartz cristallin fritté sont amincies et chaque extrémité du tube central est fusionnée avec l'extrémité d'un tube terminal en quartz fondu transparent ayant sensiblement le même diamètre interne.

2. Tube.selon la revendication 1, caractérisé en ce que l'épaisseur de paroi de la couche externe est supérieure à l'épaisseur de paroi de la couche interne.

3. Procédé de formation d'un tube selon la revendication 1 ou 2, où on dépose une composition constituée de particules de quartz cristallin finement divisées sur la face interne d'un moule cylindrique tout en faisant tourner le moule sur son axe longitudinal et en chauffant le quartz à l'aide d'un élément chauffant placé sur l'axe longitudinal du moule afin de fritter les particules de quartz cristallin en une seule pièce et de faire fusionner entre elles les particules sur la surface interne de la couche de particules déposée et en son voisinage, ce qui forme un tube à double couche ayant une couche de quartz fondu transparent interne fusionnée avec une couche de quartz cristallin fritté externe, on aminicit les extrémités de ladite couche externe dudit tube, et on fait fusionner les extrémités ouvertes du tube sur des tubes terminaux en quartz fondu transparent ayant sensiblement le même diamètre interne.

4. Procédé de formation d'un tube selon la revendication 1 ou 2, qui consiste à placer un tube de quartz fondu transparent coaxialement à l'intérieur d'un moule cylindrique en laissant un petit intervalle annulaire entre le tube et le moule, à remplir cet intervalle au moyen d'une composition de quartz constitué de particules de quartz cristallin finement divisées, à rendre compacte la composition par centrifugation en faisant tourner ledit moule et en chauffant cette composition à l'aide d'un élément chauffant disposé coaxialement vis-à-vis du tube, de manière à provoquer le frittage des particules en une seule pièce et à fusionner les particules avec le tube de quartz fondu transparent interne, ce qui permet de former un tube à double couche possédant une couche de quartz fondu transparent interne fusionnée avec une couche de quartz cristallin fritté externe, à amincir les extrémités de ladite couche externe dudit tube, puis à faire fusionner les extrémités ouvertes du tube sur des tubes terminaux en quartz fondu transparent possédant sensiblement le même diamètre interne.

5. Procédé de traitement thermique de substrats semiconducteurs, caractérisé en ce qu'on chauffe les substrats tout en les maintenant à l'intérieur d'un tube selon la revendication 1 ou 2.

## Fig. 1

## Fig. 2

## Fig. 3

(mm)

INNER DIAMETER OF QUARTZ TUBE

HEATING TIME